(19) Europäisches Patentamt
European Patent Office
Office européen des brevets

(11) Publication number: **0 127 171**
**B1**

(12) # EUROPEAN PATENT SPECIFICATION

(45) Date of publication of patent specification: **15.04.87**

(51) Int. Cl.$^4$: **G 03 F 7/26**

(21) Application number: **84106079.1**

(22) Date of filing: **28.05.84**

(54) **Developing liquid for photoresist.**

(30) Priority: **31.05.83 JP 96143/83**

(43) Date of publication of application:
**05.12.84 Bulletin 84/49**

(45) Publication of the grant of the patent:
**15.04.87 Bulletin 87/16**

(84) Designated Contracting States:
**DE GB IT**

(56) References cited:
**EP-A-0 023 758**
**EP-A-0 062 733**

**EXTENDED ABSTRACTS, THE ELECTROCHEMICAL SOCIETY, INC., FALL MEETING, 17th-22nd October 1976, Las Vegas, Nevada, vol. 76-2, pages 911-913, abstract no. 354; M. ASANO et al.: "Application of choline in semiconductor technology"**

(73) Proprietor: **Kabushiki Kaisha Toshiba**
**72, Horikawa-cho Saiwai-ku**
**Kawasaki-shi Kanagawa-ken 210 (JP)**
(73) Proprietor: **TAMA CHEMICALS CO., LTD.**
**36-2, 5-chome, Kamata Oota-ku**
**Tokyo (JP)**

(72) Inventor: **Kamata, Yutaka c/o Patent Division**
**KABUSHIKI KAISHA TOSHIBA 1-1 Shibaura 1-chome**
**Minato-ku Tokyo 105 (JP)**
Inventor: **Suguro, Yuki c/o Patent Division**
**KABUSHIKI KAISHA TOSHIBA 1-1 Shibaura 1-chome**
**Minato.ku Tokyo 105 (JP)**

(74) Representative: **Henkel, Feiler, Hänzel & Partner**
**Möhlstrasse 37**
**D-8000 München 80 (DE)**

**EP 0 127 171 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to a developing liquid for photoresist.

A process for manufacturing a semiconductor device includes a photo-etching step for patterning a thin film, etc., formed on a semiconductor substrate. In the photo-etching step, the surface of a semi-conductor wafer is treated, and then coated with a photoresist film. Thereafter, the photoresist film is prebaked, and then subjected to mask alignment, exposure, development, rinsing, postbaking, etc., to form a photoresist pattern. If an alkali-soluble photoresist is used, an aqueous solution of tetramethyl ammonium hydroxide (hereinafter abbreviated TMAH) or trimethyl (hydroxyethyl) ammonium hydroxide (hereinafter abbreviated THAH) is used as a developing liquid.

Since the developing liquid formed of the aqueous solution of TMAH or THAH is high in temperature-dependence, its developing speed will vary on each occasion, failing to provide a resist film of a desired pattern size. Conventionally, therefore, a developing vessel is provided with a heat regulator for temperature control in the development, thus complicating its construction.

The object of the present invention is to provide a developing liquid for photoresist which greatly reduces fluctuations in the developing speed when used at a temperature within a predetermined range, and hence which is capable of easily forming a resist film of a desired pattern without requiring temperature control.

A developing liquid for a photoresist according to the invention comprises an aqueous solution which contains tetraalkyl ammonium hydroxide and trialkyl (hydroxylalkyl) ammonium hydroxide at a weight ratio ranging from 5:2 to 1:10.

The weight ratio between the tetraalkyl ammonium hydroxide and the trialkyl (hydroxylalkyl) ammonium hydroxide preferably ranges from 1:1 to 1:6, and, most preferably, is 1:4.

The tetraalkyl ammonium hydroxide is formulated as follows:

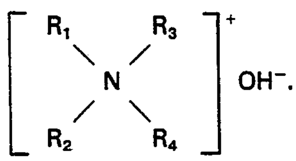

(1)

Here $R_1$, $R_2$, $R_3$ and $R_4$ are alkyl groups. These alkyl groups preferably include methyl, ethyl, propyl, and butyl groups. The most preferably used tetraalkyl ammonium hydroxide according to the invention is tetramethyl ammonium hydroxide (hereinafter abbreviated TMAH).

The trialkyl (hydroxyalkyl) ammonium hydroxide is formulated as follows:

$$[(R_1)_3N^+R_2OH]OH^-. \qquad (2)$$

Here $R_1$ is an alkyl group, and $R_2OH$ is a hydroxyalkyl group. The methyl, ethyl, propyl or butyl group is preferably used for the alkyl group, and the hydroxylmethyl, hydroxylethyl, hydroxylpropyl or hydroxylbutyl group for the hydroxylalkyl group. The most preferably used trialkyl (hydroxylalkyl) ammonium hydroxide according to the invention is trimethyl (hydroxylethyl) ammonium hydroxide (hereinafter abbreviated THAH).

TMAH($(CH_3)_4NOH$) can be obtained through a reaction between trimethylamine ($(CH_3)_3N$) and methyl bromide ($(CH_3)Br$) as follows:

$$(CH_3)_3N+(CH_3)Br \rightarrow (CH_3)_4NBr, \qquad (3)$$

$$(CH_3)_4NBr+Ag(OH) \rightarrow (CH_3)_4NOH+AgBr\downarrow. \qquad (4)$$

THAH($(CH_3)_3N(CH_2CH_2OH)OH$) can be obtained through a reaction between trimethylamine ($(CH_3)_3N$) and ethylene oxide as follows:

$$(CH_3)_3N+(CH_2)_2O+H_2O \rightarrow (CH_3)_3N(C_2H_4OH)OH. \qquad (5)$$

The weight ratio between TMAH and THAH ranging from 5:2 to 1:10 is used for the following reason.

If the content of TMAH exceeds 2.5 times that of THAH, the resultant developing liquid is not more effective than a liquid formed only of TMAH. If the content of TMAH is less than a tenth that of THAH, on the other hand, the resultant developing liquid is not more effective than a liquid formed only of THAH, and is not improved in the temperature-dependence of developing speed. For lower temperature-dependence of developing speed, the weight ratio between TMAH and THAH preferably ranges from 1:1 to 1:6, and, most preferably, is 1:4.

The developing liquid of the invention is applied to an alkali-soluble photoresist. The alkali-soluble photoresist may be of a positive or negative type. Some of positive-type photoresists contain naphthoquinone diadido as a photosensitive group and a novolac resin as the base resin. The resists of this

type include OF PR800 (trademark, Tokyo Oka Co., Ltd.), AZ1470 (trademark, Siphley Co., Ltd.), etc. Negative-type photoresists include RU-1000N -(Hitachi Kasei Co., Ltd.), etc.

The invention can be more fully understood from the following detailed description when taken in conjunction with the accompanying drawings, in which:

Fig. 1 is a graph showing the relationships between the developing speed of an exposed photoresist film and the temperatures of developing liquids; and

Fig. 2 is a graph showing the relationships between the developing speed of an unexposed photoresist film and the temperature of the developing liquids (1 Å$=10^{-10}$m).

An example of the present invention will now be described.

(Example)

First, a silicon wafer was coated with a photoresist film of a prescribed composition by the spin coating method. Then, the resultant structure was baked at 85°C for 30 minutes. After baking, the photoresist film was 1.5 μm thick. Ultraviolet rays were applied to the structure at a dose rate of 80 mJ/cm$^2$ by using a superhigh-pressure mercury lamp. Then, the structure was developed by using developing liquids I to V of the following varied compositions according to the present invention at various liquid temperatures ranging from 10 to 30°C. After developing, the thickness of the remaining photoresist film was measured to determine the developing speed. Fig. 1 shows the results of such measurement. In Fig. 1, curves I to V indicate the relationships between the liquid temperature and the developing speed for the developing liquids I to V, respectively. An unexposed photoresist film was developed in the same manner, and checked for the change of the developing speed compared with the liquid temperature. Fig. 2 shows the results of such examination. In Fig. 2, curves I' to V' indicate the relationships between the liquid temperature and the developing speed for the developing liquids I to V, respectively.

The developing liquids I to V are mixtures of a 2.3% aqueous solution of TMAH and a 4.6% aqueous solution of THAH by weight at weight ratios of 5:1, 2:1, 1:2, 1:3 and 1:5, respectively. The net weight ratios between TMAH and THAH in these individual developing liquids are shown in the table below.

TABLE

| Developing liquid | TMAH/THAH (weight ratio) |
|---|---|
| I | 5:2 |
| II | 1:1 |
| III | 1:4 |
| IV | 1:6 |
| V | 1:10 |

A developing liquid VI formed only of a 2.3% aqueous solution of TMAH by weight and a developing liquid VII formed only of a 4.6% aqueous solution of THAH by weight were prepared as controls. Under the same conditions as aforesaid, exposed and unexposed photoresist films were developed by using these developing liquids VI and VII, and were checked for the relationships between the developing speed and the liquid temperature. Curves VI and VII of Fig. 1 and curves VI' and VII' of Fig. 2 indicate the results of such an examination.

As seen from the graph of Fig. 1, the temperature-dependence of the developing speed is improved for those liquids whose weight ratios between TMAH and THAH range from 5:2 to 1:10, and especially from 1:1 to 1:6. It may be understood that the weight ratio of 1:4 provides the steadiest developing speed.

It may also be seen that the temperature-dependence of the developing speed of the developing liquid containing only TMAH or THAH is high for both exposed and unexposed photoresists.

According to the developing liquid for the photoresist of the present invention, as described above, a steady developing speed less dependent on temperature may be obtained within the temperature range of 10 to 30°C. Since development is normally performed at room temperature ranging from 20 to 26°C, it is quite unnecessary to control the temperature of the developing liquid by using a heat regulator. Also, because the normal temperature of a developing liquid storage chamber ranges from 10 to 30°C, the developing liquid can be used directly from the storage chamber.

The concentrations of the aqueous solutions of TMAH and THAH can suitably be selected according to the developing speed, photoresist film thickness, and developing time, etc.

**Claims**

1. A developing liquid for photoresist comprising an aqueous solution containing tetraalkyl

ammonium hydroxide and trialkyl (hydroxyalkyl) ammonium hydroxide at a weight ratio ranging from 5:2 to 1:10.

2. The developing liquid for photoresist according to claim 1, characterized in that said weight ratio between the tetraalkyl ammonium hydroxide and the trialkyl (hydroxyalkyl) ammonium hydroxide ranges from 1:1 to 1:6.

3. The developing liquid for photoresist according to claim 1, characterized in that said tetraalkyl ammonium hydroxide is tetramethyl ammonium hydroxide, and said trialkyl (hydroxyalkyl) ammonium hydroxide is trimethyl (hydroxyethyl) ammonium hydroxide.

4. The developing liquid for photoresist according to claim 1, characterized in that said photoresist is an alkali-soluble photoresist.

**Patentansprüche**

1. Entwicklerflüssigkeit für Photoresists in Form einer wäßrigen Lösung mit einem Tetraalkylammoniumhydroxid und einem Trialkyl(hydroxyalkyl)ammoniumhydroxid in einem Gewichtsverhältnis von 5:2 bis 1:10.

2. Entwicklerflüssigkeit für Photoresists nach Anspruch 1, dadurch gekennzeichnet, daß das Gewichtsverhältnis zwischen dem Tetraalkylammoniumhydroxid und dem Trialkyl(hydroxyalkyl)ammoniumhydroxid von 1:1 bis 1:6 reicht.

3. Entwicklerflüssigkeit für Photoresists nach Anspruch 1, dadurch gekennzeichnet, daß das Tetraalkylammoniumhydroxid aus Tetramethylammoniumhydroxid und das Trialkyl(hydroxyalkyl)ammoniumhydroxid aus Trimethyl(hydroxyethyl)ammoniumhydroxid besteht.

4. Entwicklerflüssigkeit für Photoresists nach Anspruch 1, dadurch gekennzeichnet, daß es sich bei dem Photoresist um einen alkalilöslichen Photoresist handelt.

**Revendications**

1. Un liquide de développement pour une matière photorésistante, comportant une solution aqueuse contenant du tétraalkyle ammonium hydroxide et du trialkyle (hydroxyalkyle) ammonium hydroxyde dans un rapport pondéral de 5:2 à 1:10.

2. Le liquide de développement pour une matière photorésistante selon la revendication 1, caractérisé en ce que ledit rapport pondéral entre le tétraalkyle ammonium hydroxyde et le trialkyle (hydroxyalkyle) ammonium hydroxyde est situé entre 1:1 et 1:6.

3. Le liquide de développement pour une matière photorésistante selon la revendication 1, caractérisé en ce que ledit tétraalkyle ammonium hydroxyde est du tétraméthyle ammonium hydroxyde, et en ce que ledit trialkyle (hydroxyalkyle) ammonium hydroxyde est du triméthyle (hydroxyéthyle) ammonium hydroxyde.

4. Le liquide de développement pour une matière photorésistante selon la revendication 1, caractérisé en ce que ladite matière photo-résistante est une matière photo-résistante soluble dans l'alcali.

FIG. 1

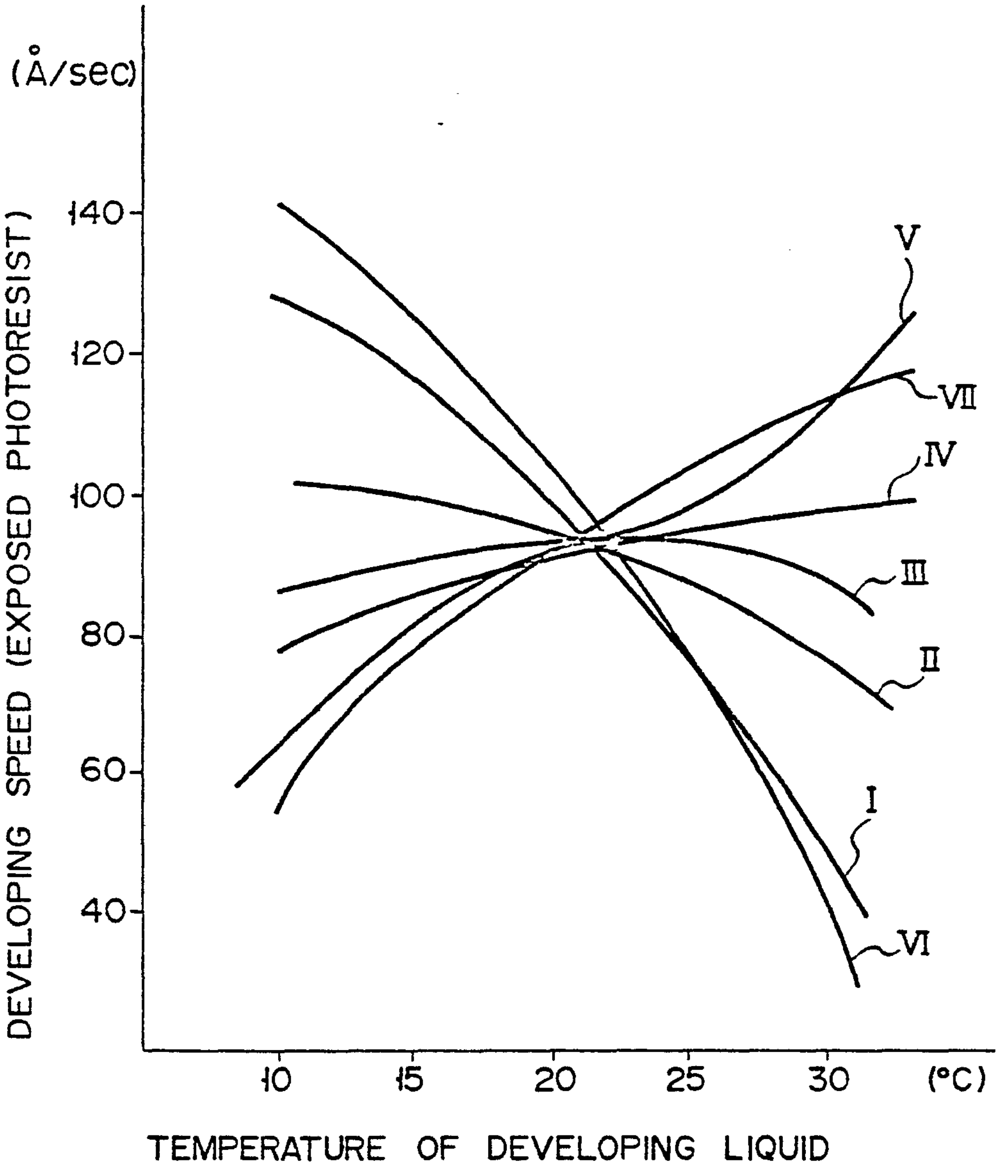
(Å/sec)
140
120
100
80
60
40
DEVELOPING SPEED (EXPOSED PHOTORESIST)
10
15
20
25
30
(°C)
TEMPERATURE OF DEVELOPING LIQUID
I
II
III
IV
V
VI
VII

FIG. 2

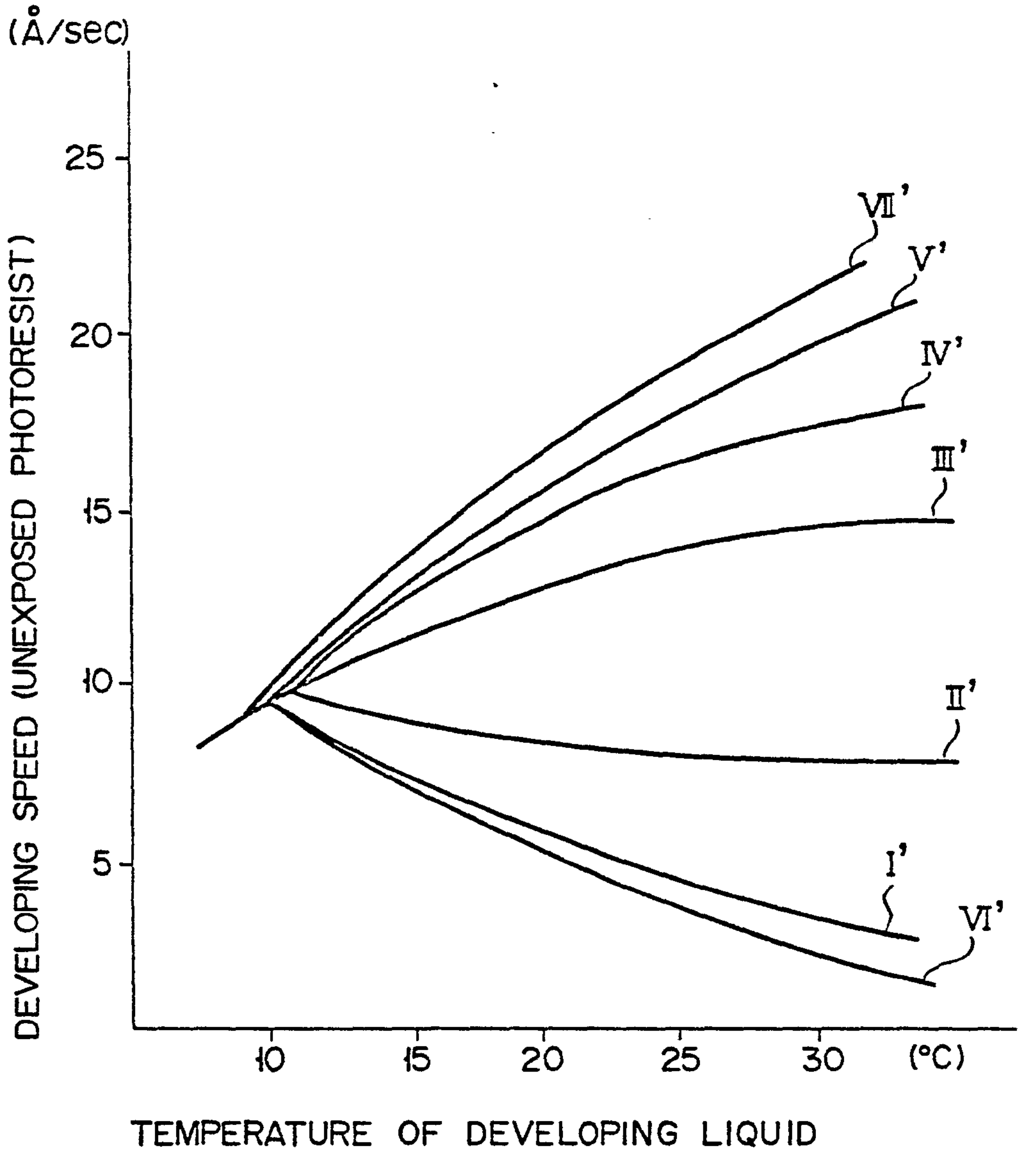
(Å/sec)
25
20
15
10
5
DEVELOPING SPEED (UNEXPOSED PHOTORESIST)
VII'
V'
IV'
III'
II'
I'
VI'
10
15
20
25
30
(°C)
TEMPERATURE OF DEVELOPING LIQUID